# EUROPEAN PATENT APPLICATION

(11) **EP 3 450 964 A1**
(43) Date of publication of application: **06.03.2019**
(21) Application number: 16889890.6
(22) Date of filing: 05.10.2016
(51) Int. Cl.: G01N 21/73, H05K 7/20

(54) **ICP ANALYSIS DEVICE**

(30) Priority: 09.02.2016 JP 2016022943
(71) Applicant: Shimadzu Corporation, Kyoto-shi, Kyoto 604-8511 (JP)
(72) Inventor: NAKANO, Tomohito, Kyoto-shi Kyoto 604-8511 (JP); SAWADA, Takuya, Kyoto-shi Kyoto 604-8511 (JP)
(74) Representative: Mewburn Ellis LLP
(86) International application number: PCT/JP2016/079590
(87) International publication number: WO 2017/138189

(57) **Abstract**

A water sensing sensor (21) is disposed at a position where the water sensing sensor (21) can sense water generated through dew condensation at a metal first valve (13) positioned upstream of a cooling unit of a high-frequency power source (3) on a circulation flow path (10) of cooling water. The first valve (13) is disposed at a position where the first valve (13) contacts with air taken in from outside the analyzer by a cooling fan. The temperature of cooling water passing through the first valve (13) is lower than the temperature of cooling water supplied to the cooling unit of the high-frequency power source (3), and the first valve (13) contacts with external air having a high humidity. As a result, dew condensation occurs in the first valve (13) earlier than in a circuit board of the high-frequency power source when a dew condensation condition is satisfied. The dew condensation is sensed by the water sensing sensor (21), and a control unit (20) stops operation of the high-frequency power source (3). Accordingly, even when the temperature of cooling water for cooling the circuit board of the high-frequency power source is too low, dew condensation can be prevented from occurring in the board, thereby avoiding failure or the like.

## Description

### TECHNICAL FIELD

The present invention relates to an inductively coupled plasma (ICP) analyzer such as an ICP mass analyzer or an ICP spectroscopic analyzer, and more particularly relates to an ICP analyzer including a cooling mechanism configured to cool a place having a high temperature at analysis by using refrigerant such as water.

### BACKGROUND ART

In an ICP mass analyzer, a nebulized specimen (inorganic substance mainly such as metal) is fed into inductively coupled plasma flame and ionized, and ions thus generated are subjected to mass analysis, thereby performing qualitative analysis and quantitative analysis of the specimen. In an ICP spectroscopic analyzer, a nebulized specimen is fed into inductively coupled plasma flame, and light emitted by heated and excited molecules and atoms of the specimen is spectroscopically analyzed, thereby performing qualitative analysis and quantitative analysis of the specimen. In the following, analyzers using inductively coupled plasma, such as an ICP mass analyzer and an ICP spectroscopic analyzer, are collectively referred to as ICP analyzers.

In an ICP analyzer, high-frequency large current is supplied to an induction coil wound around the leading end of a substantially cylindrical plasma torch, and plasma gas (typically, argon gas) fed to the plasma torch is ionized by the effect of a high-frequency magnetic field generated by the supplied current, thereby forming plasma flame. The plasma flame normally has a high temperature of several thousands °C or higher, and thus the induction coil and a specimen feed unit such as a nebulizer that are disposed around the plasma torch are heated to extremely high temperature. In addition, elements such as an electrical power MOSFET are mounted on a circuit board of a high-frequency power source configured to supply high frequency current to the induction coil, and thus the circuit board is heated to extremely high temperature due to heat generation at these elements. It is difficult to sufficiently cool these components by air cooling, and thus a conventional ICP analyzer includes a water-cooling mechanism to efficiently cool a plurality of sites at high temperature.

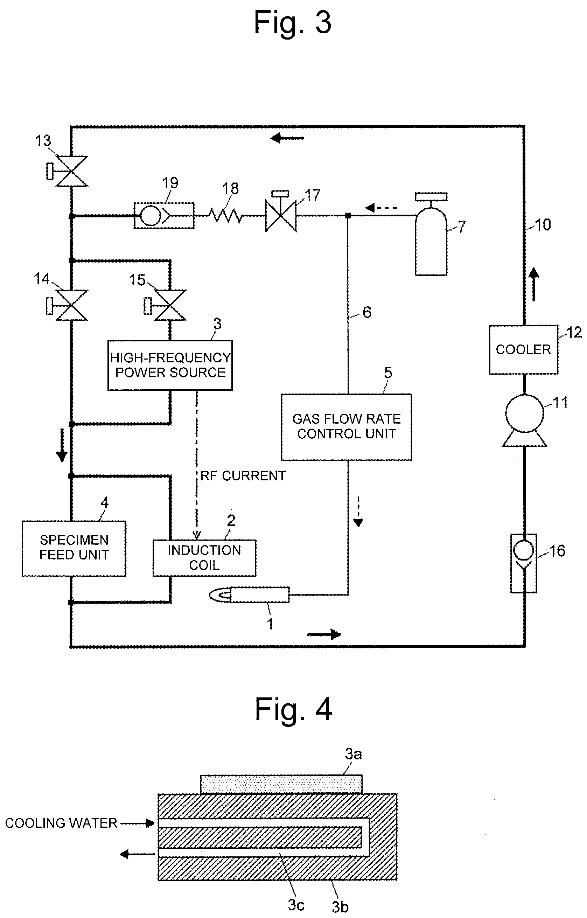

Fig. 3 is a schematic configuration diagram of main flow paths of cooling water and gas in the conventional ICP analyzer.

As indicated with arrows in Fig. 3, water cooled by a cooler 12 including, for example, a Peltier element is fed out to a circulation flow path 10 by operation of a liquid transfer pump 11. When a first valve 13 and a second valve 14 are opened and a third valve 15 is closed, cooling water flows, through the first valve 13 and the second valve 14, into a cooling unit of a specimen feed unit 4 and a cooling unit of an induction coil 2 wound around a plasma torch 1. Then, the cooling water circulates into a liquid transfer pump 11 through a check valve 16. When a high-frequency power source 3 is driven to supply high frequency current from the high-frequency power source 3 to the induction coil 2, the second valve 14 is closed and the third valve 15 is opened. Accordingly, the cooling water flows into the cooling unit of the high-frequency power source 3 through the first valve 13 and the third valve 15. As a result, a circuit board of the high-frequency power source 3 at high temperature can be cooled.

Argon gas stored in a gas tank 7 is transferred through a gas flow path 6 to a gas flow rate control unit 5 where the flow rate is adjusted, and then supplied as plasma gas or cooling gas to the plasma torch 1. The gas flow path 6 is bifurcated and one of the bifurcated paths is connected to a circulation flow path 10 through a fourth valve 17, a flow rate resistor 18, and a check valve 19. When the first valve 13 is closed, a drain valve (not illustrated) communicated with the circulation flow path 10 is opened, and then the fourth valve 17 is opened, gas flow into the circulation flow path 10 so that water remaining the circulation flow path 10 can be discharged through the drain valve.

Fig. 4 illustrates a schematic configuration of a cooling unit for cooling the circuit board of the high-frequency power source 3, which is disclosed in Patent Literature 1. A cooling water flow path 3c through which the cooling water circulates is formed in a cooling block 3b made of copper having excellent thermal conductivity, and a high-frequency power source circuit board 3a on which various circuit elements are mounted is attached to an upper surface of the cooling block 3b.

As described above, when the second valve 14 is closed and the third valve 15 is opened, the cooling water circulates through the cooling water flow path 3c. The cooling water cools the cooling block 3b and further cools the high-frequency power source circuit board 3a. The cooling water also cools the various elements mounted on the circuit board 3a. In a plasma-off duration in which the high-frequency power source 3 is not operated, the third valve 15 is closed, and thus the cooling water does not flow into the cooling water flow path 3c. Accordingly, the cooling block 3b is not cooled, which reduces the risk that dew condensation water possibly generated by cooling and water leaking from a coupling part of the cooling water flow path 3c or the like come in contact with the high-frequency power source circuit board 3a.

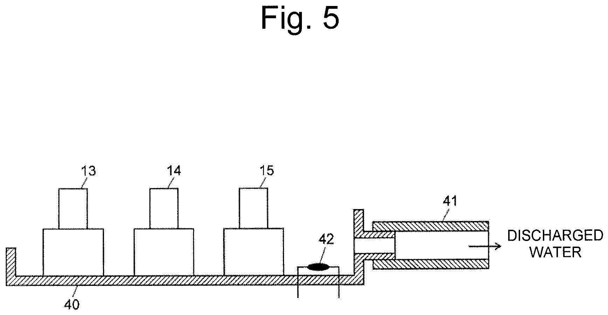

Generally, a valve includes many joint parts, and water leakage is likely to occur at one or some of the joint parts. To avoid this, in the conventional ICP analyzer, the valves 13, 14, and 15 provided in the circulation flow path 10 are put in a tray 40 having standing walls at circumference as illustrated in Fig. 5. The tray 40 is connected with a drain pipe 41 for discharging accumulated water to the outside. With this configuration, even when the cooling water leaks from a joint part of the valves 13, 14, or 15, the leaked water accumulates in the tray 40 and is prevented from sprawling to other places in the analyzer.

Such leakage of the cooling water is a kind of anomaly or failure of the analyzer. Thus, a water sensing sensor 42 configured to sense water is disposed near a bottom part of the tray 40, and when accumulation of water in the tray 40 is sensed by the water sensing sensor 42, the operation is automatically stopped or the anomaly is notified to a user.

However, an ICP analyzer including a cooling mechanism as described above has problems as follows.

The temperature of the cooling water can be freely set in a predetermined temperature range by the user, and has a lower limit of, for example, several °C (4 to 5°C). Thus, the water temperature of the cooling water may be often set to be lower than the dew point of the room in which the ICP analyzer is installed which is determined according to the room temperature and humidity. In such a case, the cooling block 3b and the high-frequency power source circuit board 3a illustrated in Fig. 4 are excessively cooled, and as a result, dew condensation may occur. When water generated through the dew condensation contacts with a circuit pattern or a mounted element on the high-frequency power source circuit board 3a, a short circuit may occur, causing a failure. Furthermore, since large current is flowing through each element on the high-frequency power source circuit board 3a, for example, firing may occur.

### CITATION LIST

### PATENT LITERATURE

Patent Literature 1: JP 2014-55785 A

### SUMMARY OF INVENTION

### TECHNICAL PROBLEM

To avoid the above-described problems, the high-frequency power source circuit board 3a can be provided with a water sensing sensor. However, the high-frequency power source circuit board 3a generates large high-frequency noise due to large high-frequency current flowing through it, and thus false sensing is likely to occur at the water sensing sensor due to the influence of the noise. Furthermore, sensing of dew condensation that has occurred in the high-frequency power source circuit board 3a is too late for prevention of a short circuit and the like in some cases.

The present invention is intended to solve the above-described problems by providing an ICP analyzer capable of preventing failure, firing, or the like of a high-frequency power source circuit board due to dew condensation even when the temperature of cooling water is set to be low.

### SOLUTION TO PROBLEM

To solve the above-described problems, the present invention provides an inductively coupled plasma analyzer configured to form inductively coupled plasma flame in a plasma torch by supplying high frequency current from a high-frequency power source to an induction coil wound around the plasma torch, the inductively coupled plasma analyzer including:
a) a power source cooling unit configured to cool a circuit board in the high-frequency power source by using refrigerant;
b) a refrigerant supply unit configured to cool refrigerant and supply the refrigerant into a refrigerant flow path to the power source cooling unit;
c) a water sensing unit disposed at a position where water generated through dew condensation at a sensing target site that is part of the refrigerant flow path and positioned upstream of the power source cooling unit and at which dew condensation is likely to occur drops or flows down; and
d) a control unit configured to receive a result of water sensing by the water sensing unit and stop operation of the high-frequency power source.

The ICP analyzer according to the present invention is, for example, an ICP mass analyzer or an ICP spectroscopic analyzer.

In the ICP analyzer according to the present invention, the sensing target site is a part of the refrigerant flow path made of a material greater than that of the other part of the refrigerant flow path, and thus the temperature at the site is relatively low (as compared to the other parts of the refrigerant flow path) by the refrigerant flowing there. Specifically, when the other parts of the refrigerant flow path are made of synthesis resin such as vinyl chloride, the sensing target site may be a pipe part made of metal such as copper or stainless steel, and is specifically, for example, a metal joint or valve.

In the ICP analyzer according to the present invention, since the sensing target site is positioned upstream of the power source cooling unit on the refrigerant flow path, the temperature of refrigerant passing through the sensing target site should be lower than the temperature of refrigerant supplied to the power source cooling unit. Thus, under such temperature and humidity conditions that dew condensation occurs in the circuit board at the power source cooling unit, dew condensation occurs in the sensing target site earlier than in the circuit board. When dew condensation occurs in the sensing target site, water thus generated drops or flows down from the sensing target site and contacts the water sensing unit. Then, the water sensing unit outputs a signal indicating that the water is sensed, and the control unit receives the signal and stops operation of the high-frequency power source. Then, the anomaly may be notified to a user through display on a display unit or emission of warning sound.

In this manner, in the ICP analyzer according to the present invention, operation of the high-frequency power source can be stopped before dew condensation occurs in the circuit board of the high-frequency power source under a condition that dew condensation can occur.

In the ICP analyzer according to the present invention, when the refrigerant flow path upstream of the power source cooling unit includes a plurality of the sensing target sites, the water sensing unit is preferably disposed at a sensing target site positioned most upstream among the plurality of the sensing target sites.

The temperature of refrigerant is lower at a position further upstream, and thus, when the water sensing unit is disposed at the sensing target site positioned most upstream, in other words, positioned closest to the refrigerant supply unit, dew condensation can be sensed earlier than a case in which the water sensing unit is disposed at another sensing target site.

In the ICP analyzer according to the present invention, the joint or valve is preferably disposed so that an upper surface of the joint or valve is tilted in one direction, or is preferably disposed on a base having an upper surface tilted in one direction, and the water sensing unit is preferably disposed below the lowest end of tilt of the upper surface of the joint or valve or tilt of the upper surface of the base.

With this configuration, a water droplet generated on the upper surface of the joint, or a water droplet dropping from the joint or valve onto the base due to dew condensation is likely to flow in one direction along the tilt. Thus, water generated through dew condensation rapidly contacts the water sensing unit.

The ICP analyzer according to a preferable aspect of the present invention further includes a fan configured to suck air outside the inductively coupled plasma analyzer and supply the air into the inductively coupled plasma analyzer, and the sensing target site is disposed at a position where the sensing target site is exposed to air flow generated by the fan.

With this configuration, the sensing target site contacts with air outside the analyzer normally having a humidity higher than that of air in the analyzer. Thus, when the humidity, the water temperature, and the like satisfy dew condensation conditions, dew condensation at the sensing target site can be promoted and sensed rapidly and reliably.

### ADVANTAGEOUS EFFECTS OF INVENTION

According to an ICP analyzer according to the present invention, when the water temperature of cooling water, the humidity of the room in which the ICP analyzer is installed, and other factors satisfy dew condensation conditions, occurrence of dew condensation can be predicted and operation of the high-frequency power source can be stopped before the dew condensation actually occurs in a circuit board of a high-frequency power source. In this manner, failure, firing, or the like of the high-frequency power source circuit board due to dew condensation can be prevented even when the temperature of cooling water is set to be low and cooling is excessive. In addition, a water sensing unit is disposed near a sensing target site as part of a refrigerant flow path. With this configuration, the water sensing unit can be separated from the high-frequency power source circuit board, and can accurately sense the existence of water without being affected by high-frequency noise by the high-frequency power source circuit board.

### BRIEF DESCRIPTION OF DRAWINGS

Fig. 1 is a schematic configuration diagram of a main part centered at a flow path of cooling water in an ICP analyzer according to an embodiment of the present invention.
Fig. 2 is a schematic configuration diagram of dew condensation water sensing at a first valve in the ICP analyzer according to the present embodiment.
Fig. 3 is a schematic configuration diagram of main flow paths of cooling water and gas in a conventional ICP analyzer.
Fig. 4 is a schematic configuration diagram of a cooling unit of a high-frequency power source circuit board in the conventional ICP analyzer.
Fig. 5 is a schematic configuration diagram for description of prevention of water leakage from a valve in the conventional ICP analyzer.

### DESCRIPTION OF EMBODIMENTS

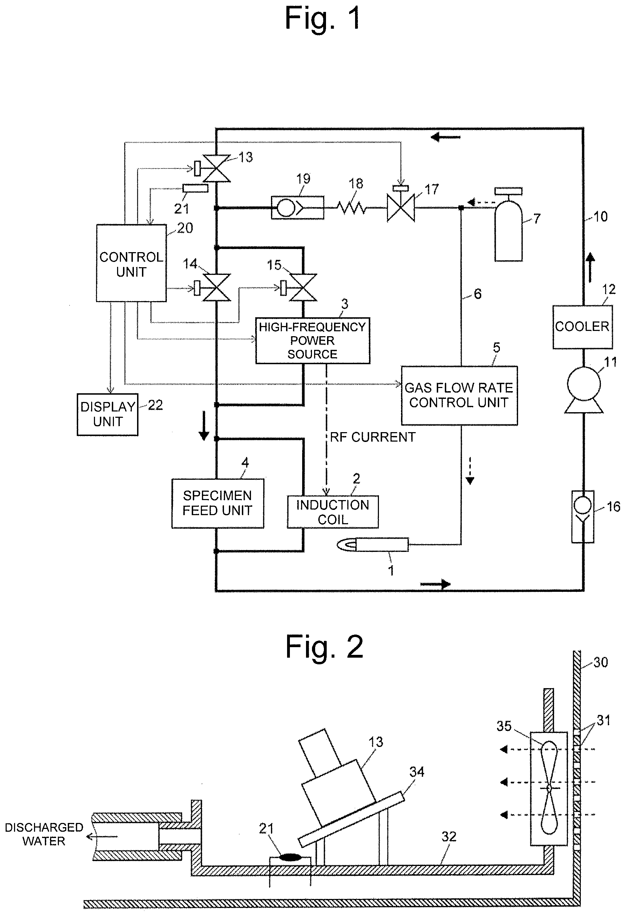

An ICP analyzer according to an embodiment of the present invention will be described below with reference to the accompanying drawings. Fig. 1 is a schematic configuration diagram of a main part centered at a flow path of cooling water in the ICP analyzer according to the present embodiment, and Fig. 2 is a schematic configuration diagram of dew condensation water sensing at a first valve 13 in the ICP analyzer according to the present embodiment. Any component identical to that in the configuration of a conventional ICP analyzer illustrated in Fig. 3 is denoted by an identical reference sign.

As understood from comparison between Figs. 1 and 3, the configuration of the flow path of cooling water in the ICP analyzer according to the present embodiment is basically same as that of the conventional ICP analyzer.

Specifically, when high-frequency large current is supplied from a high-frequency power source 3 to an induction coil 2, water (cooling water) cooled to an appropriate temperature by a cooler 12 is supplied to a cooling unit (cooling water flow path 3c in a cooling block 3b illustrated in Fig. 4) of the high-frequency power source 3 through the first valve 13 and a third valve 15. The valves 13, 14, and 15 are each made of a metal such as stainless steel. Pipe parts other than the valves 13, 14, and 15 on a circulation flow path 10 are made of synthesis resin such as vinyl chloride. Generally, metal has thermal conductivity more excellent than that of synthesis resin, and thus pipes of the valves 13, 14, and 15 are cooled to have low temperature at the surfaces of them when cooling water at low temperature is supplied, and thus dew condensation is likely to occur. In addition, the temperature of cooling water gradually increases as the cooling water flows through the circulation flow path 10. Accordingly, the cooling water passing through the first valve 13 disposed most upstream (close to the cooler 12) has a lowest temperature, and dew condensation occurs in the first valve 13 at an earliest timing.

In the ICP analyzer according to the present embodiment, a configuration as illustrated in Fig. 2 is provided to sense, at an earliest possible timing, dew condensation having occurred in the first valve 13.

Specifically, the first valve 13 is put in a tray 32, as conventionally done, to prevent dew condensation water and leaked cooling water from sprawling to the surroundings. The first valve 13 is disposed on a base 34 having a tilted upper surface so that water generated on the upper surface of the first valve 13 through dew condensation smoothly flows in one direction and drops to a predetermined narrow region. A water sensing sensor 21 is disposed below a lowest end of the tilt of the upper surface of the base 34, in other words, near a position where dew condensation water having flowed along the upper surface drops. Although not illustrated in Fig. 2, the other valves 14 and 15 may be put in the same tray 32 as illustrated in Fig. 5.

To promote dew condensation at the surface of the first valve 13 when the temperature and humidity of the room in which the ICP analyzer is installed and the temperature of cooling water satisfy conditions of dew condensation, the first valve 13 is disposed downwind of a cooling fan 35 provided the inner side of a ventilation hole 31 formed in a housing 30. When the cooling fan 35 is driven, air outside the housing 30 (air in the room) is taken into the housing 30 through the ventilation hole 31, and the first valve 13 is exposed to the intake air.

Normally, external air has a humidity higher than that of air accumulated in the ICP analyzer, and thus dew condensation is likely to occur when the external air contacts with the first valve 13 having a decreased temperature. In addition, water generated through dew condensation at the surface of the first valve 13 is likely to move downwind due to the flow of air sent from the cooling fan 35. Accordingly, minute droplets of the dew condensation water are likely to gather to become large droplets, and flow down along the tilt of the upper surface of the valve 13 and the tilt of the upper surface of the base 34 or drop from the lowest ends of the tilts. Thus, dew condensation can be sensed early as compared to a case in which the first valve 13 is installed at a position where the first valve 13 does not contact with the flow of external air from the cooling fan 35.

Since the first valve 13 is installed at a position separated from the high-frequency power source 3 to some extent, the water sensing sensor 21 is unlikely to be affected by high-frequency noise emitted from the high-frequency power source 3. Thus, occurrence of false sensing by the water sensing sensor 21 can be prevented as well.

When sensing dew condensation based on a sensing signal from the water sensing sensor 21, a control unit 20 stops operation of the high-frequency power source 3 by stopping supply of electrical power to a high-frequency power source circuit board 3a in the high-frequency power source 3. A display unit 22 performs anomaly notification indicating the stopping of operation due to dew condensation. Accordingly, high-frequency current supply from the high-frequency power source 3 to the induction coil 2 is stopped, and plasma is turned off. In addition, gas supply to a plasma torch 1 is stopped as necessary. Once electrical power supply to the high-frequency power source circuit board 3a is stopped, generation of failure such as a short circuit due to any dew condensation occurred in the circuit board 3a thereafter can be avoided.

In the above-described embodiment, dew condensation water generated at the first valve 13 is sensed, but dew condensation water generated at the third valve 15 positioned upstream of the high-frequency power source 3 may be sensed. However, dew condensation normally occurs in the third valve 15 at a later timing than in the first valve 13, and thus the sensing is preferably performed by the first valve 13 positioned further upstream, in other words, close to the cooler 12.

When, for example, a metal joint for coupling a pipe made of synthesis resin is provided on the circulation flow path 10 in addition to the valves 13 to 15, water generated through dew condensation at the surface of the joint instead of the valves 13 and 15 may be sensed by the same method as described above.

Rightly, the above-described embodiment is merely an example of the present invention, and the claims of the present application include change, correction, and addition made as appropriate in the scope of the present invention.

### REFERENCE SIGNS LIST

1... Plasma Torch
2... Induction Coil
3... High-Frequency Power Source
3a... High-Frequency Power Source Circuit Board
3b... Cooling Block
3c... Cooling Water Flow Path
4... Specimen Feed Unit
5... Gas Flow Rate Control Unit
6... Gas Flow Path
7... Gas Tank
10... Circulation Flow Path
11... Liquid Transfer Pump
12... Cooler
13... First Valve
14... Second Valve
15... Third Valve
16, 19... Check Valve
17... Fourth Valve
18... Flow Rate Resistor
20... Control Unit
21... Water Sensing Sensor
30... Housing
31... Ventilation Hole
32... Tray
34... Base
35... Cooling Fan

## Claims

1. An inductively coupled plasma (ICP) analyzer configured to form inductively coupled plasma flame in a plasma torch by supplying high frequency current from a high-frequency power source to an induction coil wound around the plasma torch, the ICP analyzer comprising:
a) a power source cooling unit configured to cool a circuit board in the high-frequency power source by using refrigerant;
b) a refrigerant supply unit configured to cool refrigerant and supply the refrigerant into a refrigerant flow path to the power source cooling unit;
c) a water sensing unit disposed at a position where water generated through dew condensation at a sensing target site that is part of the refrigerant flow path and positioned upstream of the power source cooling unit and at which dew condensation is likely to occur drops or flows down; and
d) a control unit configured to receive a result of water sensing by the water sensing unit and stop operation of the high-frequency power source.

2. The ICP analyzer according to claim 1, wherein, when the refrigerant flow path upstream of the power source cooling unit includes a plurality of the sensing target sites, the water sensing unit is disposed at a sensing target site positioned most upstream among the plurality of the sensing target sites.

3. The ICP analyzer according to claim 1 or 2, wherein the sensing target site is a metal joint or valve.

4. The ICP analyzer according to claim 3, wherein
the joint or valve is disposed so that an upper surface of the joint or valve is tilted in one direction, or is disposed on a base having an upper surface tilted in one direction, and
the water sensing unit is disposed below a lowest end of tilt of the upper surface of the joint or valve or tilt of the upper surface of the base.

5. The ICP analyzer according to any one of claims 1 to 4, further comprising a fan configured to suck air outside the ICP analyzer and supply the air into the ICP analyzer, wherein the sensing target site is disposed at a position where the sensing target site is exposed to air flow generated by the fan.
